# EUROPEAN PATENT APPLICATION

(11) **EP 2 014 735 A2**
(43) Date of publication of application: **14.01.2009**
(21) Application number: 07747885.7
(22) Date of filing: 09.04.2007
(51) Int. Cl.: C09J 9/02, C09J 163/00, H01L 23/48

(54) **POLYMER ANISOTROPIC ELECTROCONDUCTIVE GLUING MATERIAL AND A GLUING METHOD**

(30) Priority: 13.04.2006 RU 2006112264
(71) Applicant: Koltsova, Anastasia Adrianovna, Moscow 117419 (RU); Nikitina, Yuna Evgenevna, Moscow 129626 (RU); Latchinov, Alexei Nikolaevich, Ufa 450083 (RU); Salazkin, Sergei Nikolaevich, Moscow 117449 (RU)
(72) Inventor: LATCHINOV, Alexei Nikolaevich, Ufa 450083 (RU); SALAZKIN, Sergei Nikolaevich, Moscow 117449 (RU)
(74) Representative: von Füner, Nicolai
(86) International application number: PCT/RU2007/000167
(87) International publication number: WO 2007/120078

(57) **Abstract**

The invention relates to the semiconductor device making technology, namely, to methods and compositions for the technology for manufacturing semiconductor devices and integrated microcircuits, particularly to the technology for creating new adhesive electroconductive compositions.

The task of the claimed invention is in providing a polymer anisotropic electroconductive composite adhesive material ensuring increased reliability of positive characteristic replication, high electroconductivity and high anisotropy in the direction perpendicular to the adhesion plane, as well as a method of adhering.

The set task is solved by creating a polymer anisotropic electroconductive composite adhesive material based on dielectrics, among which the necessary component ensuring high anisotropy are agents having unstable electron molecular state, which electroconductivity depends on action of external physical fields, and which are **characterized by** high polarizability and/or bistable electron energy structure with regard to the process of excess electron capture. Other components carry out important, but ancillary functions (e.g., increasing of strength, adhesion, workability, etc.). Novelty is in that such a polymer composite material is created based only on dielectrics, among which must be necessary components having features represented above.

## Description

### Field of the Invention

The invention relates to the semiconductor device making technology, namely, to methods and compositions for the technology for manufacturing semiconductor devices and integrated microcircuits, particularly to the technology for creating new adhesive electroconductive compositions.

### Background of the Invention

Known is an electroconductive adhesive composition for die-bonding integrated microcircuit chips, the composition comprising: a polymer binder in the form of solution of phenol-formaldehyde resol resin in ethanol, the resin obtained with ammonia as a catalyst, and solution of butadiene rubber in butyl acetate, the both solutions being taken in the weight ratio 100 to 230-270 and having viscosity in accordance to the B3-1 not less than 13 s; and a filler in the form of carbonyl nickel and zirconium powders having particle size up to 10 mkm, characterized in that, in order for increasing reliability of articles by means of improving ohmic contact of chip with a metallized contact pad of a body and improving heat-sink cooling by increasing thermal conductivity, electrical conductivity and tension capacity of the adhesive composition, copper and chrome powders having particle size up to 10 mkm are introduced into the filler at the following component ratio (weight %):

| | | |
|---|---|---|
| Carbonyl nickel powder | 0.1 | 0.2 |
| Zirconium powder | 0.15 | 0.30 |
| Chrome powder | 0.35 | 0.75 |
| Copper powder | 98.75 | 99.4, |

and an amount of the filler in the electroconductive adhesive composition being selected of 26-50 weight % (see RU 2076394 C1, H01L 23/29, 1997).

The disadvantage of this adhesive composition and similar analogues known from the foreign patent documentation whose essence being in usage of non-conductive dielectric matrix filled with conducting particles that could be formed spherical or elliptical is as follows. The conductivity effect is provided by means of conducting particles. However, properties of these compositions depend on properties of the conducting particles and uniformity of their dispersion in the matrix material, the conducting powder should have particle size of a great degree of identity in size (10 mkm), which complicates the technology.

Known is an electroconductive adhesive composition for die-bonding semiconductor device and integrated microcircuit chips, comprising an epoxy resin as the polymer binder and a mixture of powders of silicon, nickel, carbon, titanium etc. (EP 0205686, H01L 23/48, 1986).

This adhesive composition does not ensure a reliable connection stable to various temperature changes, to humidity, and as a consequence, does not ensure the high reliability.

Also known is the closest to the claimed material a polymer anisotropic electroconductive composite adhesive material including a thermosetting resin selected from the group comprising epoxy, urethane and unsubstituted polyester resins, and electroconductive particles dispersed in the thermosetting resin and being resin particles coated with a metal layer (see US 6,426,021 B1, H01B 1/02, H01L 23/29, 2002).

This polymer anisotropic electroconductive composite adhesive material is difficult for manufacture, since it requires a complex and precise equipment for manufacturing equidimensional microscopic particles from organic material, which need to be coated with one or two layers of different metals of nanowidth by the electrochemical deposition technique in order to achieve the claimed purposes. Moreover, the proposed material ensures its advantages in comparison with other ones under not only adhesive characteristics of the components, but also the ratio of mechanical properties of the organic core of the electroconductive particles, metal coat of the organic core of the electroconductive particles, and surfaces being adhered. As a consequence, achievement of the high conductivity and anisotropy thereof in one direction perpendicular to the adherence surface depends on a great number of parameters difficult for monitoring, and therefore is not sufficiently reliable.

Multicomponentness of the material combines with the complex hierarchical organization thereof, which undergoes, at various technological stages, multiple structure and chemical transformations each of which is critical for obtaining the final positive effect.

Also known is a connection method including a step of sandwiching with an anisotropically electroconductive adhesive material, wherein electroconductive particles are dispersed in a thermosetting resin between electrodes of an electronic element and conductors of a mounting panel, said particles being selected from a group comprising metal particles, resin particles coated with a metal, and complex particles having an inorganic powder bound with the resin core and coated with the metal film, and a thermosetting resin selected from groups comprising epoxy, urethane and polyester resins, and by heating and applying pressure in order to produce connection therebetween and at the same time to provide continuity between electrical elements and circuit board (EP 0205686, H01L 23/48, 1986). However, in this method, it is difficult to ensure technological conditions required for achieving the positive effect, since the task for applying pressure is multifunctional and consists in that in the necessity to provide continuity of a medium being adhered, to determinate the percolation threshold between electroconductive particles, where the percolation must be only in the determinated direction. Unessential deviations both in physical-chemical material composition and in environmental conditions (fluctuations of temperature, atmospheric composition, pressure, etc.) results either in percolation failure and electroconductivity absence, or in appearance of 3-D percolation and disappearance of electroconductivity anisotropy effect. This complicates the technology of applying this material and decreases reliability of replication of properties thereof.

Moreover, presence of electroconductive particles dispersed in a dielectric matrix results in uncontrollable redistribution of surface density of contact regions, which restricts a use of such filled materials in the current trend to minimize area of element electrodes being contacted and maximize their number and density at the circuit board surface.

### Summary of the Invention

The task of the claimed invention is in providing a polymer anisotropic electroconductive composite adhesive material having increased reliability of positive characteristic replication, high electroconductivity and high anisotropy in the direction perpendicular to the adhesion plane.

Said task is solved by providing a polymer anisotropic electroconductive composite adhesive material including at least one active component ensuring anisotropic electroconductivity and at least one target additive in effective amount, the material comprising, as the active component ensuring anisotropic electroconductivity, a dielectric component possessing high polarizability and/or bistable electron energy structure with regard to the process of excess electron capture.

Said task is also solved by the fact that the material comprises, as said active dielectric component, low-molecular-weight, oligomeric and/or polymer agents having phthalide group, sulphophthalide group, phthalimidine group, o-keto-carboxylic group, o-keto-carboxylic group derivatives, and/or labile triarylmethane group.

Said task is also solved by the fact that the material comprises, as the low-molecular-weight phthalide-containing agent, diarylphthalides.

Said task is also solved by the fact that the material comprises diarylphthalides of the following structure: 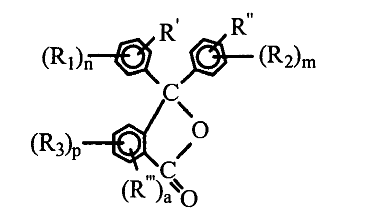 where R1, R2 and R3 = H, alkyl, aryl, alkylenearyl, alkoxy, phenoxy, etc.
R', R" and R"' are functional groups: 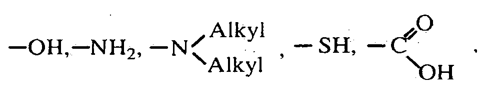 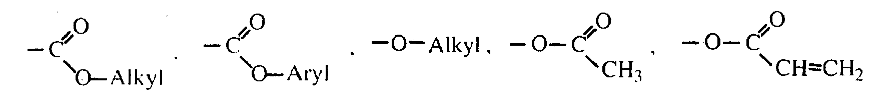 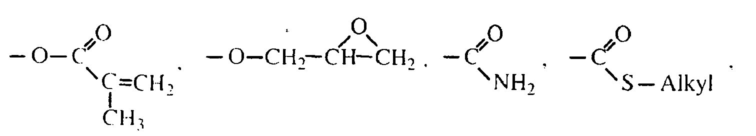 haloid, CN, NO₂, etc,
a, n, m, p are from 0 to 4.

Said task is also solved by the fact that the material comprises, as the low-molecular-weight agent, agents having a structure of diarylphthalide and/or triarylmethane fluorescein, eosin and/or rhodamines.

Said task is also solved by the fact that the material comprises, as the low-molecular-weight agent having sulphophthalide groups, diaryl sulphophthalides.

Said task is also solved by the fact that the material comprises, as the low-molecular-weight agent having phthalimidine groups, diaryl phthalimidines.

Said task is also solved by the fact that the material comprises, as the low-molecular-weight agent having o-keto-carboxylic groups and derivatives thereof, agents of the following structure capable for cyclo-chain tautomerism: 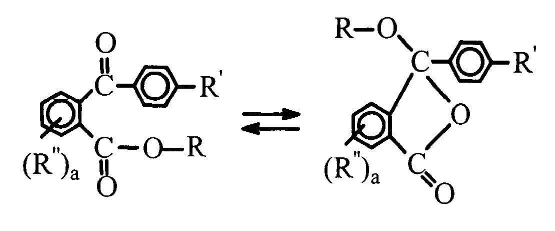 where R = H, alkyl, aryl,
R' = H, alkyl, aryl, OH, alkoxy, phenoxy,
R" = haloid, nitro, alkyl,
a is from 0 to 4.

Said task is also solved by the fact that the material comprises, as the oligomer agent having phthalide groups, hetero-chain epoxy oligomer on the basis of phenolphthalein.

Said task is also solved by the fact that the material comprises, as the oligomer agent having phthalide groups, resol type carbon-chain phenol-formaldehyde oligomer on the basis of phenolphthalein or fluorescein.

Said task is also solved by the fact that the material comprises resol type carbon-chain phenol-formaldehyde cooligomer on the basis of mixture of phenol with phenolphthalein or fluorescein at their ratio from 40/60 to 98/2.

Said task is also solved by the fact that the material comprises, as the polymer agent, homopolymers and/or copolymers containing in both main polymer chain and side branches thereof the following groups: phthalide, sulphophthalide, phthalimidine, o-keto-carboxylic and/or derivative thereof, and/or labile triarylmethane.

Said task is also solved by the fact that the material comprises, as the polymer agent having phthalide groups, hetero-chain aromatic polymers of the following types: aromatic polyesters (polyacrylates or polycarbonates); aromatic polyethers including polyarylene ether ketones, polyarylene ether sulphones; aromatic polythioethers; polyarylene sulphones; aromatic polyoxadiazoles; aromatic polyimides.

Said task is also solved by the fact that the material comprises, as the hetero-chain polymers having phthalide groups, polyarylene phthalides combining in their chain heterocycles with only one heteroatom 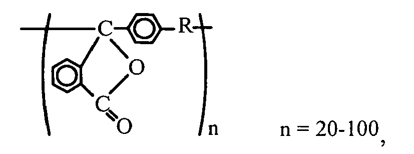 where 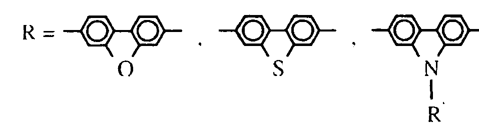 R' is alkyl.

Said task is also solved by the fact that the material comprises, as the polymer agent having phthalide groups, carbon-chain polymers.

Said task is also solved by the fact that the material comprises, as the carbon-chain polymers having phthalide groups, polyarylene ketones of the following structure:

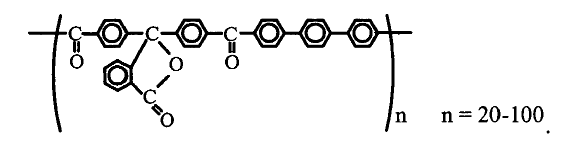

Said task is also solved by the fact that the material comprises, as the carbon-chain polymers having phthalide groups, polyarylene phthalides of the following structure: 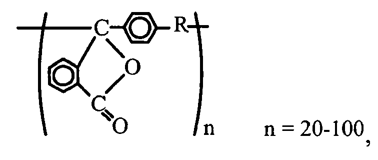 where

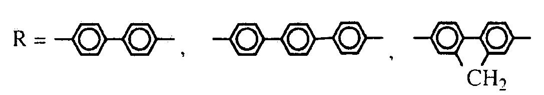

Said task is also solved by the fact that the material comprises, as the carbon-chain polymers having phthalide groups, polyacrylates and polymethacrylates having phthalide groups in side branches of the polymer chain: 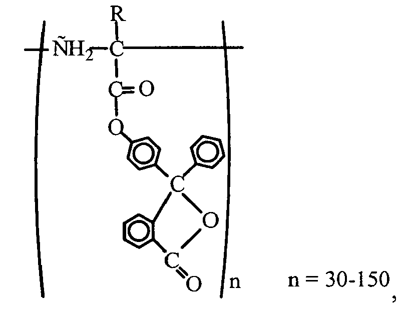 where R = H, CH₃.

Said task is also solved by the fact that the material comprises, as the polymer agent having sulphophthalide groups, polyarylene sulphophthalides of the following structure: 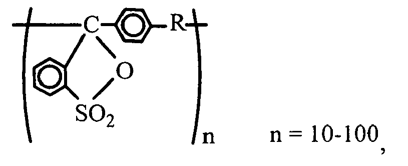 where

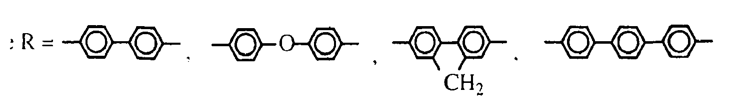

Said task is also solved by the fact that the material comprises, as the polymer agent having phthalimidine groups, hetero-chain aromatic polymers of the following types: aromatic polyesters (polyacrylates); aromatic polyethers including polyarylene ether ketones and polyarylene ether sulphones.

Said task is also solved by the fact that the material comprises, as the polymer agent having phthalimidine groups, carbon-chain aromatic polymers of the following structure: 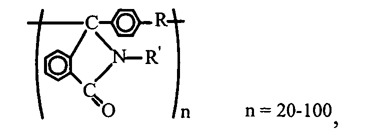 where

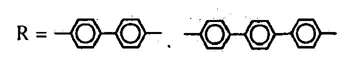

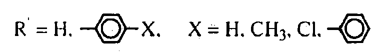

Said task is also solved by the fact that the material comprises, as the polymer agent having derivatives of the o-keto-carboxylic group, hetero-chain aromatic polyethers of the following type: 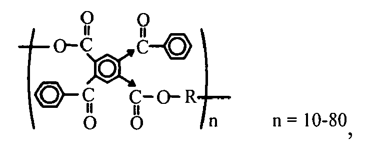 where

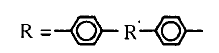

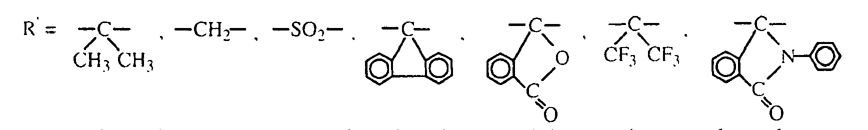

said task is also solved by the fact that the material comprises, as the polymer agent having derivatives of the o-keto-carboxylic group, hetero-chain aromatic polyethers of the following type:
"cyclic" ("pseudo") derivatives 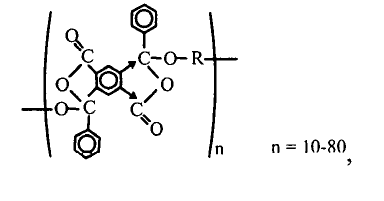
where

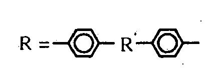

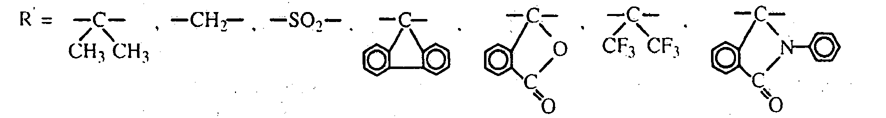

Said task is also solved by the fact that the material comprises, as the polymer agent having derivatives of the o-keto-carboxylic group, carbon-chain polyarylenes of the following type: 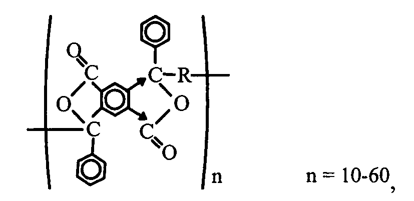 where H-R-H are aromatic polynuclear hydrocarbons: diphenyl, terphenyl, anthracene, pyrene, benzopyrene.

Said task is also solved by the fact that the material comprises, as the polymer agent having derivatives of the o-keto-carboxylic group, hetero-chain copolyethers, in which both isomeric ether forms ("normal" and "cyclic") are combined: 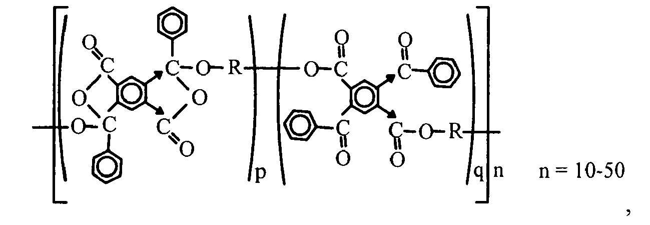 where 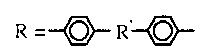 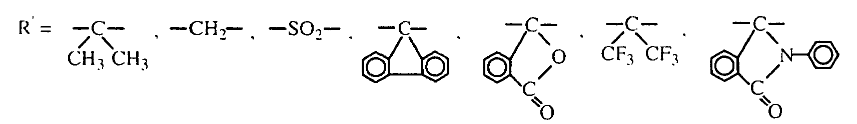 where p/q is from 0.95/0.05 to 0.05/0.95.

Said task is also solved by the fact that the material comprises, as the polymer agent, both linear and cross-linked polymers formed during adhering from low-molecular and oligomer agents.

Said task is also solved by the fact that the material comprises, as the target additive, "common" low-molecular, oligomer, and/or polymer agents in total amount from 10 to 99 weight %.

Said task is also solved by the fact that the material comprises, as the "common" low-molecular agents, monoglycidyl alcohol and phenol ethers, diglycidyl ether, diglycidyl diol and diphenol ethers, glycidyl amine derivatives, methylol phenol derivatives, colophony, diisocyanates, diols, methacrylates, acrylates, α-cyanacrylates, plastifiers, hardening agents.

Said task is also solved by the fact that the material comprises, as the "common" oligomer agents: phenol-formaldehyde oligomers, oligomer diols, oligomer diisocyanares and/or oligomer polyphenols.

Said task is also solved by the fact that the material comprises, as "common" polymer agents: aliphatic polyesters, aromatic polyesters, aromatic polyethers, polyacrylates and polymethacrylates, polyvinyl acetates and polyvinyl ketals, polyurethanes and polyureas, cross-linked polyepoxides formed during adhering, cross-linked phenol-formaldehyde systems formed during adhering.

Said task is also solved by providing a method for adhering while using the above polymer anisotropic electroconductive composite adhesive material, the method comprising steps of: applying, onto surfaces being adhered, a solution of said material in an organic solvent, joining the surfaces being adhered after evaporating the solvent, and pressing the surfaces being adhered while thermal processing till melting said material or till melting with chemical interaction of components of said material, which results in creating linear or cross-linked polymer systems.

Said task is also solved by providing a method for adhering while using the above polymer anisotropic electroconductive composite adhesive material, the method comprising steps of: applying, onto surfaces being adhered, said liquid material, joining the surfaces being adhered, and pressing the surfaces being adhered while thermal processing, which provides better spreading or better spreading and progressing the chemical interaction, which results in creating linear or cross-linked polymer systems.

Said task is also solved by providing a method for adhering while using the above polymer anisotropic electroconductive composite adhesive material, the method comprising steps of: placing said material in the form of film between surfaces being adhered, joining the surfaces being adhered, and pressing the surfaces being adhered while thermal processing, which provides better spreading or better spreading and progressing the chemical interaction, which results in creating linear or cross-linked polymer systems.

The essence of the invention is in that the claimed anisotropic electroconductive composite adhesive material includes several functional components which purpose is in providing a firm mechanical fastening of the electronic element on the circuit board and ensuring a reliable electrical contact. In principle, some components of the anisotropic electroconductive composite adhesive material can combine these functions. Most often, in order for providing the adhesive characteristics of the electroconductive material various junctions like resins, e.g., epoxy resins are used.

The layer of the anisotropic electroconductive adhesive material is a thin film with the thickness being in the range of 5 to 30 mkm, which is adhesively-linked with surfaces of electrodes and has good strength properties provided by physical-chemical peculiarities of the procedure of solidifying the anisotropic electroconductive adhesive material in which the electroconductive regions in the form of channels or cords are amid the isolating matrix of the binding agent or agent composition.

### Description of the Embodiments of the Invention

### Example 1

Floating viscous composition of epoxy oligomer ED-20 (100 weight parts, w.p.) (see claims 28, 29), phenyl glycidyl ether (11 w.p.) (see claim 28) and diglycidyl phenolphthalein ether (8 w.p.) (see claim 4) was mixed with polyethylene polyamine (12 w.p.) (see claim 29). After the beginning of the composition viscosity rise, the viscous composition was applied onto the electrode surfaces being adhered, which surfaces were cleaned in advance from possible contamination by conventional techniques. Then the surfaces were aligned and fixed using small uniaxial pressure during 40 to 60 minutes at 20 to 25 °C or during 5 to 15 minutes at 60 to 70 °C. The electrical resistivity measured across the layer was not more than 10⁻⁴ Ohm·cm. The electric strength of the adhesive along the layer at 20 °C was not less than 16 kV/mm.

### Example 2

Viscous composition of epoxy oligomer ED-20 (100 w.p.) (see claims 28, 29), diglycidyl diethylene glycol ether (5 w.p.) (see claim 28) and diglycidyl phenolphthalein ether (5 w.p.) (see claim 4) was mixed with diethylene triamine (10 w.p.) (see claim 29). After the beginning of the composition viscosity rise, the viscous composition was applied onto the electrode surfaces being adhered, then the surfaces were aligned and fixed during 30 to 60 minutes at 35 to 45 °C. Electrical characteristics are at the level described in the Example 1.

### Example 3

Solution of composition of epoxy oligomer ED-20 (100 w.p.) (see claims 28, 29), epoxy oligomer (MM = 540-560) on the basis of phenolphthalein (10 w.p.) (see claim 9) in methylene chloride (40 w.p.) was mixed with di(cyanoethyle)triethylenetetramine (12 w.p.) (see claim 29) and applied onto the electrode surfaces being adhered. Drying was carried out in the open air during 15 to 45 minutes. Then the surfaces were aligned and fixed during 25 to 45 minutes at 60 to 70 °C. Electrical characteristics are at the level described in the Example 1.

### Example 4

Solution of diglycidyl phenolphthalein ether (100 w.p.) (see claim 4) in toluene (30 w.p.) was mixed with triethylenetetramine (10 w.p.) (see claim 29) and applied onto the electrode surfaces being adhered. Drying was carried out in the open air during 15 to 45 minutes. Then the surfaces were aligned and fixed during 15 to 25 minutes at 60 to 70 °C. Electrical characteristics are at the level described in the Example 1.

### Example 5

Viscous composition of epoxy oligomer ED-20 (100 w.p.) (see claims 28, 29), phenolphthalein (1 w.p.) (see claim 4), 4,4'-bitolylphthalide (1 w.p.) (see claim 4), 3,3-bis(4'-methoxyphenyl)phthalide (2 w.p.) (see claim 4) and 3,3-bis(4'-carboethoxyphenyl)phthalide (1 w.p.) (see claim 4) was mixed with diethylenetriamine (11 w.p.) (see claim 29). After the beginning of the composition viscosity rise, the composition was applied onto the electrode surfaces being adhered, then the surfaces were aligned and fixed during 40 to 60 minutes at 40 to 50 °C. Electrical characteristics are at the level described in the Example 1.

### Example 6

Viscous composition of epoxy oligomer ED-20 (100 w.p.) (see claims 28, 29), diglycidyl diethylene glycol ether (10 w.p.) (see claim 28), fluorescein (1 w.p.) (see claim 5), diphenylsulphophthalid (2 w.p.) (see claim 6) and 3,3-bis(4'-methoxyphenyl)phthalide (2 w.p.) (see claim 4) was mixed with di(cyanoethyle)triethylenetetramine (12 w.p.) (see claim 29). After the beginning of the composition viscosity rise, the composition was applied onto the electrode surfaces being adhered, then the surfaces were aligned and fixed during 40 to 60 minutes at 30 to 40 °C. Electrical characteristics are at the level described in the Example 1.

### Example 7

Viscous composition of epoxy oligomer ED-20 (100 w.p.) (see claims 28, 29), diphenyl sulphophthalide (2 w.p.) (see claim 6), 3-phenyl-,3(4'-hydroxyphenyl)phthalide (2 w.p.) (see claim 4) and diphenylphthalide (2 w.p.) (see claim 4) was mixed with diethylenetriamine (11 w.p.) (see claim 29). After the beginning of the composition viscosity rise, the composition was applied onto the electrode surfaces being adhered, then the surfaces were aligned and fixed during 20 to 40 minutes at 50 to 60 °C. Electrical characteristics are at the level described in the Example 1.

### Example 8

Viscous composition of epoxy oligomer ED-20 (100 w.p.) (see claims 28, 29), phenylglycidyl ether (5 w.p.) (see claim 28), diglycidyl phenolphthalein ether (5 w.p.) (see claim 4), neutral form of rhodamine C (1 w.p.) (see claim 4 or 5) - 3,3-bis(4'-N,N-diethylaminophenyl)phthalide, and neutral form of benzoyl green (1 w.p.) (see claim 5) - di(4-N,N-dimethylaminophenyl)phenylmethane was mixed with diethylenetriamine (12 w.p.) (see claim 29). After the beginning of the composition viscosity rise, the composition was applied onto the electrode surfaces being adhered, then the surfaces were aligned and fixed during 20 to 40 minutes at 50 to 60 °C. Electrical characteristics are at the level described in the Example 1.

### Example 9

Viscous composition of epoxy oligomer ED-20 (100 w.p.) (see claims 28, 29), diglycidyl diethylene glycol ether (11 w.p.) (see claim 28), phenolphthalein (1 w.p.) (see claim 4) and polyarylene ether ketone (4 w.p.) (see claim 13) on the basis of phenolphthalein and 4,4'-difluoro-benzene phenon was mixed with triethylene tetramine (12 w.p.) (see claim 29). After the beginning of the composition viscosity rise, the composition was applied onto the electrode surfaces being adhered, then the surfaces were aligned and fixed during 10 to 30 minutes at 60 to 70 °C. Electrical characteristics are at the level described in the Example 1.

### Example 10

Composition of α-cyanoethyl acrylate (100 w.p.) (see claim 28), 3,3-bis(4'-methoxyphenyl)phthalide (2 w.p.) (see claim 4), bitolylphthalide (1 w.p.) (see claim 4) and diphenylsulphophthalide (2 w.p.) (see claim 6) was applied onto the electrode surfaces being adhered, then the surfaces were aligned and fixed during 1 to 3 minutes at 20 to 25 °C. Electrical characteristics are at the level described in the Example 1.

### Example 11

Composition of copolymer (20 w.p.) (see claim 30) of methylmethacrylate and butylmethacrylate in methylmethacrylate (80 w.p.) (see claim 28), 3-phenyl-3(4'-phenylmethacrylate)phthalide (1 w.p.) (see claim 4) and diglycidyl phenolphthalein ether (5 w.p.) (see claim 4) was mixed with benzoyl peroxide (0.5 w.p.) and N,N-dimethylaniline (0.5 w.p.), then, after the beginning of the composition viscosity rise, the composition was applied onto the electrode surfaces being adhered. The surfaces were aligned and fixed during 15 to 60 minutes at 25 to 50 °C. Electrical characteristics are at the level described in the Example 1. While adhering transparent electrodes, the photocuring of this composition is possible.

### Example 12

Composition of novolac SF-010 (100 w.p.) (see claim 29), 2,6-dimethylol-p-cresol (35 w.p.) (see claim 28), phenolphthalein (5 w.p.) (see claim 4), fluoresceine (1 w.p.) (see claim 5), polydiphenylenephthalide (1 w.p.) (see claim 17), and cyclohexanone (300 w.p.) was applied onto the electrode surfaces being adhered. Drying was carried out in the open air during 15 to 45 minutes. Then the surfaces were aligned and fixed during 15 to 30 minutes at 150 °C, or during 6 to 30 minutes at 180 °C. Electrical characteristics are at the level described in the Example 1.

### Example 13

Composition of novolac SF-010 (100 w.p.) (see claim 29), 2,6-dimethylol-p-cresol (35 w.p.) (see claim 28), phenolphthalein (3 w.p.) (see claim 4), diphenylsulphophthalide (1 w.p.) (see claim 6), polyarylate (aromatic polyester) (1 w.p.) (see claim 13) on the basis of phenolphthalein and terephthaloyl chloride, and cyclohexanone (300 w.p.) was applied onto the electrode surfaces being adhered. The surfaces were aligned and fixed during 6 to 30 minutes at 180 °C. Electrical characteristics are at the level described in the Example 1.

### Example 14

Composition of novolac SF-010 (100 w.p.) (see claim 29), 2,6-dimethylol-p-cresol (30 w.p.) (see claim 28), phenolphthalein (3 w.p.) (see claim 4), 3-ethoxy-3-phenylphthalide (2 w.p.) (see claim 8), ethyl o-benzoylbenzoate (2 w.p.) (see claim 8), polyarylene ether ketone (5 w.p.) (see claim 13) on the basis of phenolphthalein and 4,4'-difluoro-benzene phenon, and cyclohexanone (300 w.p.) was applied onto the electrode surfaces being adhered. Drying was carried out in the open air during 15 to 45 minutes. Then the surfaces were aligned and fixed during 10 to 30 minutes at 180 °C. Electrical characteristics are at the level described in the Example 1.

### Example 15

Composition of novolac SF-010 (100 w.p.) (see claim 29), 2,6-dimethylol-p-cresol (35 w.p.) (see claim 28), phenolphthalein (3 w.p.) (see claim 4), rhodamine C (2 w.p.) (see claim 4 or 5), benzoyl green (2 w.p.) (see claim 5), polyarylene ether sulphone (5 w.p.) (see claim 13) on the basis of phenolphthalein and 4,4'-difluoro-diphenyl sulphone, and cyclohexanone (300 w.p.) was applied onto the electrode surfaces being adhered. Drying was carried out in the open air during 15 to 45 minutes. Then the surfaces were aligned and fixed during 10 to 30 minutes at 180 °C. Electrical characteristics are at the level described in the Example 1.

### Example 16

Composition of resol-300 (100 w.p.) (see claim 29), phenolphthalein (5 w.p.) (see claim 4), polydiphenylene sulphophthalide (1 w.p.) (see claim 19), and cyclohexanone (300 w.p.) was applied onto the electrode surfaces being adhered. Drying was carried out in the open air during 15 to 45 minutes. Then the surfaces were aligned and fixed during 10 to 30 minutes at 180 °C. Electrical characteristics are at the level described in the Example 1.

### Example 17

Composition of polyvinylbutyral (100 w.p.) (see claim 30), phenol-formaldehyde resin resol-300 (30 w.p.) (see claim 29), resol type cooligomer (1.3 w.p.) (see claim 11) obtained by polycondensation of formaldehyde with the mixture of phenol and phenolphthalein at weight ratio of phenol and phenolphthalein of 40/60, ethanol and/or cyclohexanone (900 w.p.) was applied onto the electrode surfaces being adhered. Drying was carried out in the open air during 15 to 45 minutes. Then the surfaces were aligned and fixed during 10 to 30 minutes at 150 °C. Electrical characteristics are at the level described in the Example 1.

### Example 18

Composition of polyvinylbutyral (100 w.p.) (see claim 30), resol type cooligomer (30 w.p.) (see claim 11) obtained by polycondensation of formaldehyde with the mixture of phenol and phenolphthalein at weight ratio of phenol and phenolphthalein of 98/2, ethanol and/or cyclohexanone (900 w.p.) was applied onto the electrode surfaces being adhered. Drying was carried out in the open air during 15 to 45 minutes. Then the surfaces were aligned and fixed during 15 to 60 minutes at 120 to 150 °C. Electrical characteristics are at the level described in the Example 1.

### Example 19

Composition of polyvinylfurfural (100 w.p.) (see claim 30), 3,3-bis(4'-carboxyphenyl)phthalide (3 w.p.) (see claim 4), resol type cooligomer (30 w.p.) (see claim 11) obtained by polycondensation of formaldehyde with the mixture of phenol and phenolphthalein at weight ratio of phenol and phenolphthalein of 80/20, ethanol and/or cyclohexanone (900 w.p.) was applied onto the electrode surfaces being adhered. Drying was carried out in the open air during 15 to 45 minutes. Then the surfaces were aligned and fixed during 20 to 120 minutes at 175 to 185 °C. Electrical characteristics are at the level described in the Example 1.

### Example 20

Composition of polyvinylbutyral (100 w.p.) (see claim 30), resol type cooligomer (30 w.p.) (see claim 11) obtained by polycondensation of formaldehyde with the mixture of phenol and phenolphthalein at weight ratio of phenol and phenolphthalein of 40/60, o-benzoylbenzoic acid (5 w.p.) (see claim 8) was applied in the form of film between the surfaces being adhered, and the surfaces were fixed during 5 to 30 minutes at 150 to 160 °C. Electrical characteristics are at the level described in the Example 1.

### Example 21

Composition of triethylene glycol (25 w.p.) (see claim 29), 3,3-bis(4'-methoxyphenyl)phthalide (1 w.p.) (see claim 4), 3-ethoxy-3-phenylphthalide (1 w.p.) (see claim 8) was mixed with adduct of toluene diisocyanate and 1,4-butylene glycol (73 w.p.) (see claim 29), which adduct containing acetone solution of ethyl o-benzoylbenzoate (2 w.p.) (see claim 8) and diphenyl sulphophthalide (1 w.p.) (see claim 6). After the beginning of the viscosity rise, the composition was applied onto the electrode surfaces being adhered. Drying was carried out in the open air during 15 to 45 minutes. Then the surfaces were aligned and fixed during 60 to 90 minutes at 80 to 110 °C. Electrical characteristics are at the level described in the Example 1.

### Example 22

Composition of novolac SF-010 (100 w.p.) (see claim 29), 2,6-dimethylol-p-cresol (35 w.p.) (see claim 28), polymethylmethacrylate (5 w.p.) (see claim 30), 2-phenyl-3,3-bis(4'-hydroxyphenyl)phthalimidine (3 w.p.) (see claim 7), 3,3-bis(4'-carboxyphenyl)phthalide (5 w.p.) (see claim 4), and cyclohexanone (300 w.p.) was applied onto the electrode surfaces being adhered, and the composition was dried in the open air. Then the surfaces were aligned and fixed during 5 to 10 minutes at 180 °C. Electrical characteristics are at the level described in the Example 1.

### Example 23

Composition of resol-300 (100 w.p.) (see claim 29), poly[3-phenyl-3(4'-phenylacrylate)phthalide] (5 w.p.) (see claim 18), polyarylene ether ketone (1 w.p.) (see claim 16) on the basis of 3,3-bis(4'-carboxyphenyl)phthalide dichloride and terphenyl, and cyclohexanone (300 w.p.) was applied onto the electrode surfaces being adhered, and the composition was dried in the open air. Then the surfaces were aligned and fixed during 5 to 6 minutes at 180 °C. Electrical characteristics are at the level described in the Example 1.

### Example 24

Composition of polyarylene ether ketone (100 w.p.) (see claim 13) on the basis of 4,4'-difluoro-benzene phenone and mixture of bisphenols: bisphenol A and phenolphthalein (at their molar ratio of 90/10); 3,3-bis(4'-methoxyphenyl)phthalide (5 w.p.) (see claim 4), 3,3-bis(4'-carboxyphenyl)phthalide (5 w.p.) (see claim 4), and cyclohexanone (300 w.p.) was applied onto the electrode surfaces being adhered, and the composition was dried in the open air. Then the surfaces were aligned and fixed with the material melt applied thereupon during 30 to 50 seconds at 200 to 210 °C. Electrical characteristics are at the level described in the Example 1.

### Example 25

Composition of polyarylene ether ketone (50 w.p.) (see claim 30) on the basis of 4,4'-difluoro-benzene phenone and bisphenol A, polyarylene ether ketone (50 w.p.) (see claim 13) on the basis of 4,4'-difluoro-benzophenone and mixture of bisphenols: bisphenol A and phenolphthalein (at their molar ratio of 50/50), diglycidyl ether of phenolphthalein (10 w.p.) (see claim 4), colophony (5 w.p.) (see claim 28), and cyclohexanone (900 w.p.) was applied onto the electrode surfaces being adhered, and the composition was dried in the open air. Then the surfaces were aligned and fixed with the material melt applied thereupon during 30 to 60 seconds at 200 to 210 °C. Electrical characteristics are at the level described in the Example 1.

### Example 26

Composition of epoxy oligomer ED-20 (100 w.p.) (see claim 28, 29), epoxy oligomer (MM = 540-560) on the basis of phenolphthalein (10 w.p.) (see claim 9), polyarylate (aromatic polyester) (10 w.p.) (see claim 13) on the basis of phenolphthalein and isophthalic acid dichloride, polyarylate (5 w.p.) (see claim 20) on the basis of isophthalic acid dichloride and 2-phenyl-3,3-bis(4'-hydroxyphenyl)phthalimidine and methylene chloride (200 w.p.) was applied onto the electrode surfaces being adhered, and the composition was dried in the open air. Then the surfaces were aligned and fixed during 40 to 60 minutes at 220 °C. Electrical characteristics are at the level described in the Example 1.

### Example 27

Composition of epoxy oligomer (MM = 540-560) on the basis of phenolphthalein (90 w.p.) (see claim 9), phenyl glycidyl ether (10 w.p.) (see claim 28), diethylenetriamine (12 w.p.) (see claim 29), polyarylenephthalide containing fragments of dibenzofuran (1 w.p.) (see claim 14), polydiphenylene-N-phenylphthalimidine (1 w.p.) (see claim 21), and methylene chloride (200 w.p.) was applied onto the electrode surfaces being adhered, and the composition was dried in the open air. Then the surfaces were aligned and fixed during 3 to 8 minutes at 80 to 100 °C. Electrical characteristics are at the level described in the Example 1.

### Example 28

Composition of epoxy oligomer ED-20 (100 w.p.) (see claim 28, 29), epoxy oligomer (MM = 540-560) on the basis of phenolphthalein (15 w.p.) (see claim 9), polyarylene ether ketone (5 w.p.) (see claim 13, 20) on the basis of 4,4'-difluoro-benzene phenone and mixture of bisphenols: phenolphthalein and phenolphthalein-imide (at their molar ratio of 75/25), polyether (15 w.p.) (see claim 22) in "normal form" on the basis of 2,5-dibenzoylterephthalic acid pseudo-chloranhydride and bisphenol A, and methylene chloride (200 w.p.) was applied onto the electrode surfaces being adhered, and the composition was dried in the open air. Then the surfaces were aligned and fixed during 15 to 30 minutes at 200 to 220 °C. Electrical characteristics are at the level described in the Example 1.

### Example 29

Composition of polyvinylbutyral (100 w.p.) (see claim 30), colophony (15 w.p.) (see claim 28), resol type cooligomer (100 w.p.) (see claim 11) obtained by polycondensation of formaldehyde with the mixture of phenol and phenolphthalein (at weight ratio of phenol and phenolphthalein of 60/40), polyarylenephthalide (1 w.p.) (see claim 24) on the basis of 2,5-dibenzoylterephthalic acid pseudo-chloranhydride and diphenyl, polyester in "cyclic form" (2 w.p.) (see claim 23) on the basis of 2,5-dibenzoylterephthalic acid pseudo-chloranhydride and bisphenol A, copolyester (mixture of "cyclic form" and "normal form" at p/q = 0.90/0.10) (2 w.p.) (see claim 25) on the basis of 4,6-dibenzoylterephthalic acid pseudo-chloranhydride and bisphenol A, and cyclohexanone (900 w.p.) was applied onto the electrode surfaces being adhered, and the composition was dried in the open air. Then the surfaces were aligned and fixed during 2 to 3 minutes at 200 °C. Electrical characteristics are at the level described in the Example 1.

### Example 30

Composition of epoxy oligomer (MM = 540-560) on the basis of phenolphthalein (100 w.p.) (see claim 9), polyarylate (aromatic polyester) (20 w.p.) (see claim 13) on the basis of isophthalic acid dichloride and phenolphthalein, triethanolamine titanate (10 w.p.) (claim 28), and methylene chloride (300 w.p.) was applied onto the electrode surfaces being adhered, and the composition was dried in the open air. Then the surfaces were aligned and fixed during 15 to 30 seconds at 200 to 220 °C or during 1 to 3 minutes at 170 °C. Electrical characteristics are at the level described in the Example 1.

### Example 31

Composition of epoxy oligomer (MM = 540-560) on the basis of phenolphthalein (100 w.p.) (see claim 9), polyarylate (aromatic polyester) (20 w.p.) (see claim 30) on the basis of 9,9-bis(4'-hydroxyphenyl)fluorene and mixture of isophthaloyl and terephthaloyl chlorides (at their molar ratio of 80/20, respectively), triethanolamine titanate (10 w.p.) (claim 28), and methylene chloride (300 w.p.) was applied onto the electrode surfaces being adhered, and the composition was dried in the open air. Then the surfaces were aligned and fixed during 30 to 50 seconds at 200 °C. Electrical characteristics are at the level described in the Example 1.

### Example 32

Composition of epoxy resin EHD (100 w.p.) (see claim 28, 29), 3,3-bis(4'-methoxyphenyl)phthalide (5 w.p.) (see claim 4), polyarylate (25 w.p.) (see claim 13) on the basis of isophthaloyl chloride and phenolphthalein, and methylene chloride (300 w.p.) was applied onto the electrode surfaces being adhered, and the composition was dried in the open air. Then the surfaces were aligned and fixed during 30 to 60 minutes at 200 °C. Electrical characteristics are at the level described in the Example 1.

### Specific Implementation Example

Polyvinylbutyral, dibutyl cebacate, resol type cooligomer obtained by polycondensation of formaldehyde with the mixture of phenol and phenolphthalein at weight ratio of phenol and phenolphthalein of 60/40, colophony according to the State Standard (ΓOCT) 19113-84, ethanol or cyclohexanone at part weight ratio of 0.84:0.16:0.3:0.1:9, were mixed till complete dissolving of solid components. The obtained solution was applied onto the electrode surfaces being adhered with a layer having a thickness not more than 1 mm. The aforementioned surfaces were cleaned in advance form possible contamination by conventional techniques. The anisotropic electroconductive adhesive material was dried in the open air during 15 to 45 minutes, then the surfaces being adhered were aligned and fixed using small uniaxial pressure, and were heated at temperature in the range of 120 to 150 °C during 45 to 15 minutes.

The layer thickness of the anisotropic electroconductive adhesive material applied onto the surfaces being adhered is specified by that at less thickness the applied amount of the material is insufficient for ensuring a firm joint, and at more thickness a portion of the material will squeeze out beyond the adherence area and will not be used for providing the positive effect.

The time interval of drying the anisotropic electroconductive material in the open air is selected from the considerations that in a time less than 15 minutes the great amount of solvent remains in the material volume, which could result in encapsulating a portion thereof and/or in forming microvoids in the material volume during thermal processing. The latter results in quality deterioration of the adhesive line, reduction of its strength and surface adhesive force. Increase of the drying time more than 45 minutes does not result in additional enhancement of the positive effect, and therefore is considered to be inexpedient.

The temperature range of thermal processing is selected from the considerations of ensuring the maximal thermosetting efficiency. At a temperature of 120 °C, this process becomes ineffective, and at temperatures higher than 150 °C arises a probability of thermal decomposition of polyvinylbutyral and, respectively, loss of a portion of its positive properties.

The time interval of thermosetting is defined by a requirement for ensuring the effective cross-link of the polymer component.

As electronic and electrotechnical element samples being adhered were used:
- cards from copper-foil-clad dielectric like laminated bakelite, glass-fiber laminate, polyimide, having a system of parallel flat conductors;
- films from polyethylene terephthalate having conductors produced by the screen print technique from an electroconductive silver-containing paste;
- separate conductors from copper and aluminium;
- plates from glass covered with a transparent electroconductive coat from alloys of indium and tin oxides, that are used for producing liquid-crystal flat displays and units;
- light-emitting diodes having flat electrodes;
- filament lamps having wire electrodes;
- metal foil;
- et al.

### Test results

Tests of the obtained compound were carried out in accordance with the (Russian) Specifications Ty 4542-001-12695289-99, paragraph 49.3, and Ty 4542-001-1269289-99, paragraph 47.1, as well as at the temperature of +97 °C during 45 minutes. Moreover, the samples were subjected to a temperature thrust that was carried out by dipping the adhesive junction sample heated to the temperature of +90 °C into a vessel with liquid nitrogen (-196 °C). All carried out tests bring the positive result. The main results of the carried out tests are shown in the Table 1.

**Table 1. The main parameters of the anisotropic electroconductive adhesive material obtained in the process of testing**

| No | Parameter name, unit of measurement | Result of testing the anisotropic electroconductive adhesive material | Measuring technique or characteristic |
|---|---|---|---|
| 1. | Density, g/cm³ | 1.07 - 1.10 | ΓOCT 15139-69 |
| 2. | Mass fraction of non-volatile matters, % | Not less than 10 | ΓOCT 17537-72 |
| 3. | Thickness of adhesive layer between appressed conductors, mkm | Not less than 10 | - |
| 4. | Thermosetting mode: - setting temperature, °C - setting time, h - pressure, MPa | 120 - 150 ± 5 5 0.25 - 0.75 Not less than 0.05 MPa | Set of necessary and sufficient conditions of impact onto the adhesive layer |
| 5. | Water absorption of the solidified adhesive at 20 °C, % | 1 - 3 | ΓOCT 21513-76 ΓOCT 4650-80 |
| 6. | Joint shear strength of adhered copper samples at 20 °C, MPa | Not less than 8.5 (≈ 85 kgf/cm²) | ΓOCT 14759-69 |
| 7. | Dielectric strength of solidified adhesive along layer at 20 °C, kV/mm | 16 | ΓOCT 6433.3-71 |
| 8. | Elasticity of free solidified adhesive layer when bending at 20 °C | Absence of cracks | According to ΓOCT 6806-73 |
| 9. | Electrical resistivity measured across layer, Ohm·cm | Not more than 10⁻⁴ | |

## Claims

1. A polymer anisotropic electroconductive composite adhesive material including at least one active component ensuring anisotropic electroconductivity and at least one target additive in effective amount, the material comprising, as the active component ensuring anisotropic electroconductivity, a dielectric component possessing high polarizability and/or bistable electron energy structure with regard to the process of excess electron capture.

2. The polymer anisotropic electroconductive composite adhesive material according to claim 1, **characterized in that** said material comprises, as said active dielectric component, low-molecular-weight, oligomeric and/or polymer agents having phthalide group, sulphophthalide group, phthalimidine group, o-keto-carboxylic group, o-keto-carboxylic group derivatives, and/or labile triarylmethane group.

3. The polymer anisotropic electroconductive composite adhesive material according to claim 2, **characterized in that** said material comprises, as the low-molecular-weight phthalide-containing agent, diarylphthalides.

4. The polymer anisotropic electroconductive composite adhesive material according to claim 3, **characterized in that** said material comprises diarylphthalides of the following structure: 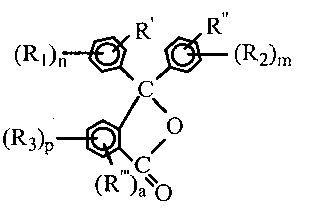 where R1, R2 and R3 = H, alkyl, aryl, alkylenearyl, alkoxy, phenoxy,
R', R" and R"' are functional groups: 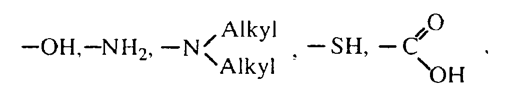 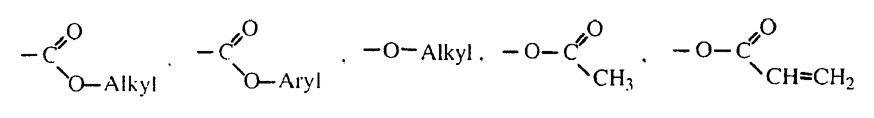 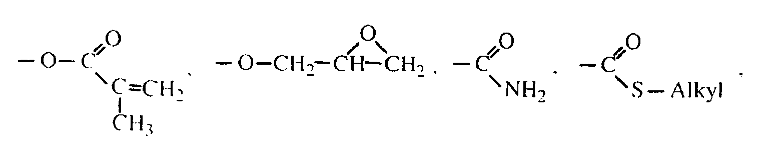 haloid, CN, NO₂, etc,
a, n, m, p are from 0 to 4.

5. The polymer anisotropic electroconductive composite adhesive material according to claim 2, **characterized in that** said material comprises, as the low-molecular-weight agent, agents having a structure of diarylphthalide and/or triarylmethane fluorescein, eosin and/or rhodamines.

6. The polymer anisotropic electroconductive composite adhesive material according to claim 2, **characterized in that** said material comprises, as the low-molecular-weight agent having sulphophthalide groups, diaryl sulphophthalides.

7. The polymer anisotropic electroconductive composite adhesive material according to claim 2, **characterized in that** said material comprises, as the low-molecular-weight agent having phthalimidine groups, diaryl phthalimidines.

8. The polymer anisotropic electroconductive composite adhesive material according to claim 2, **characterized in that** said material comprises, as the low-molecular-weight agent having o-keto-carboxylic groups and derivatives thereof, agents of the following structure capable for cyclo-chain tautomerism: 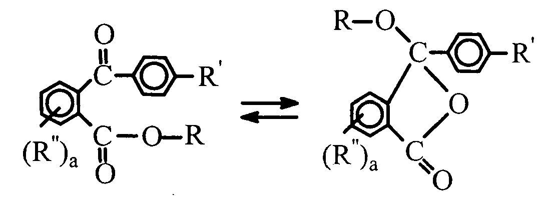 where R = H, alkyl, aryl,
R' = H, alkyl, aryl, OH, alkoxy, phenoxy,
R" = haloid, nitro, alkyl,
a is from 0 to 4.

9. The polymer anisotropic electroconductive composite adhesive material according to claim 2, **characterized in that** said material comprises, as the oligomer agent having phthalide groups, hetero-chain epoxy oligomer on the basis of phenolphthalein.

10. The polymer anisotropic electroconductive composite adhesive material according to claim 2, **characterized in that** said material comprises, as the oligomer agent having phthalide groups, resol type carbon-chain phenol-formaldehyde oligomer on the basis of phenolphthalein or fluorescein.

11. The polymer anisotropic electroconductive composite adhesive material according to claim 2, **characterized in that** said material comprises resol type carbon-chain phenol-formaldehyde cooligomer on the basis of mixture of phenol with phenolphthalein or fluorescein at their ratio from 40/60 to 98/2.

12. The polymer anisotropic electroconductive composite adhesive material according to claim 2, **characterized in that** said material comprises, as the polymer agent, homopolymers and/or copolymers containing in both main polymer chain and side branches thereof the following groups: phthalide, sulphophthalide, phthalimidine, o-keto-carboxylic and/or derivative thereof, and/or labile triarylmethane.

13. The polymer anisotropic electroconductive composite adhesive material according to claim 12, **characterized in that** said material comprises, as the polymer agent having phthalide groups, hetero-chain aromatic polymers of the following types: aromatic polyesters (polyacrylates or polycarbonates); aromatic polyethers including polyarylene ether ketones, polyarylene ether sulphones; aromatic polythioethers; polyarylene sulphones; aromatic polyoxadiazoles; aromatic polyimides.

14. The polymer anisotropic electroconductive composite adhesive material according to claim 13, **characterized in that** said material comprises, as the hetero-chain polymers having phthalide groups, polyarylene phthalides combining in their chain heterocycles with only one heteroatom 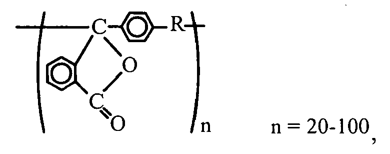 where 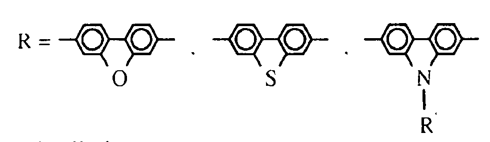 R' is alkyl.

15. The polymer anisotropic electroconductive composite adhesive material according to claim 12, **characterized in that** said material comprises, as the polymer agent having phthalide groups, carbon-chain polymers.

16. The polymer anisotropic electroconductive composite adhesive material according to claim 15, **characterized in that** said material comprises, as the carbon-chain polymers having phthalide groups, polyarylene ketones of the following structure:

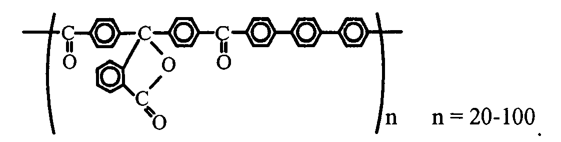

17. The polymer anisotropic electroconductive composite adhesive material according to claim 15, **characterized in that** said material comprises, as the carbon-chain polymers having phthalide groups, polyarylene phthalides of the following structure: 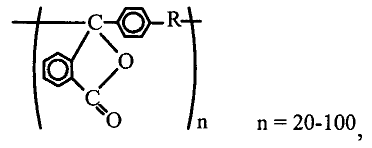 where

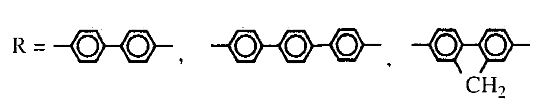

18. The polymer anisotropic electroconductive composite adhesive material according to claim 15, **characterized in that** said material comprises, as the carbon-chain polymers having phthalide groups, polyacrylates and polymethacrylates having phthalide groups in side branches of the polymer chain: 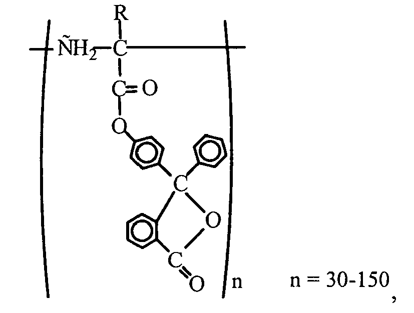 where R = H, CH₃.

19. The polymer anisotropic electroconductive composite adhesive material according to claim 12, **characterized in that** said material comprises, as the polymer agent having sulphophthalide groups, polyarylene sulphophthalides of the following structure: 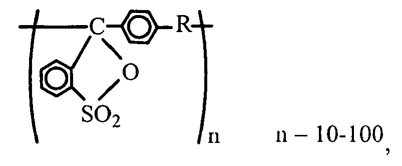 where

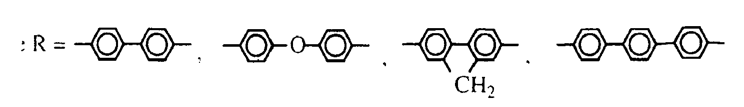

20. The polymer anisotropic electroconductive composite adhesive material according to claim 12, **characterized in that** said material comprises, as the polymer agent having phthalimidine groups, hetero-chain aromatic polymers of the following types: aromatic polyesters (polyacrylates); aromatic polyethers including polyarylene ether ketones and polyarylene ether sulphones.

21. The polymer anisotropic electroconductive composite adhesive material according to claim 12, **characterized in that** said material comprises, as the polymer agent having phthalimidine groups, carbon-chain aromatic polymers of the following structure: 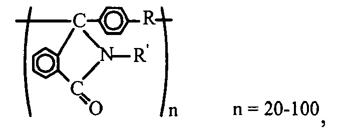 where

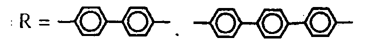

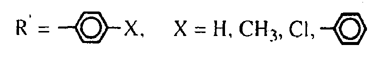

22. The polymer anisotropic electroconductive composite adhesive material according to claim 12, **characterized in that** said material comprises, as the polymer agent having derivatives of the o-keto-carboxylic group, hetero-chain aromatic polyethers of the following type: 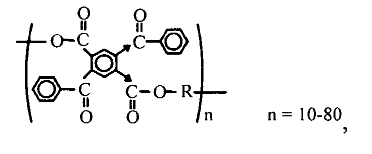 where

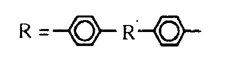

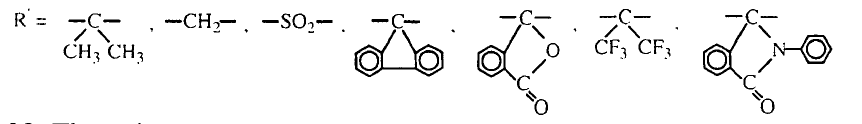

23. The polymer anisotropic electroconductive composite adhesive material according to claim 12, **characterized in that** said material comprises, as the polymer agent having derivatives of the o-keto-carboxylic group, hetero-chain aromatic polyethers of the following type:
"cyclic" ("pseudo") derivatives 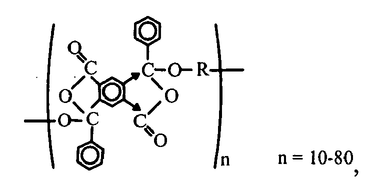
where

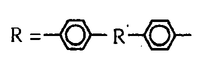

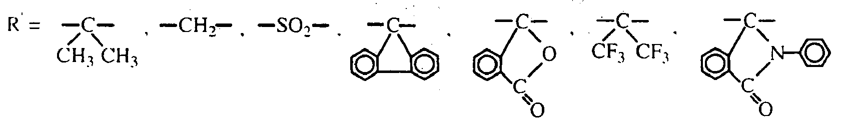

24. The polymer anisotropic electroconductive composite adhesive material according to claim 12, **characterized in that** said material comprises, as the polymer agent having derivatives of the o-keto-carboxylic group, carbon-chain polyarylenes of the following type: 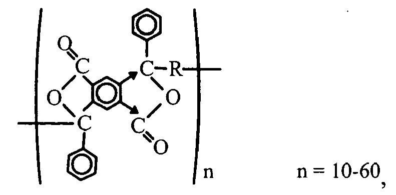 where H-R-H are aromatic polynuclear hydrocarbons: diphenyl, terphenyl, anthracene, pyrene, benzopyrene.

25. The polymer anisotropic electroconductive composite adhesive material according to claim 12, **characterized in that** said material comprises, as the polymer agent having derivatives of the o-keto-carboxylic group, hetero-chain copolyethers, in which both isomeric ether forms ("normal" and "cyclic") are combined: 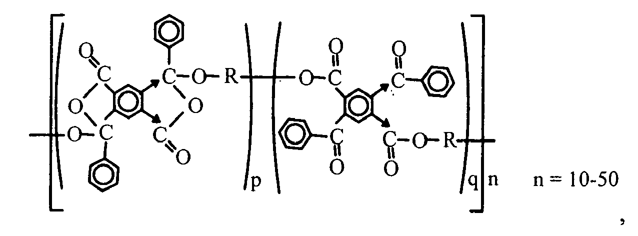 where 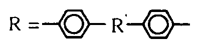 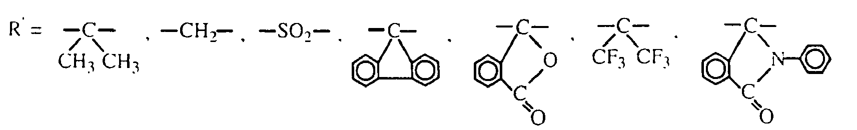 where p/q is from 0.95/0.05 to 0.05/0.95.

26. The polymer anisotropic electroconductive composite adhesive material according to claim 12, **characterized in that** said material comprises, as the polymer agent, both linear and cross-linked polymers formed during adhering from low-molecular and oligomer agents.

27. The polymer anisotropic electroconductive composite adhesive material according to claim 1, **characterized in that** said material comprises, as the target additive, "common" low-molecular, oligomer, and/or polymer agents in total amount from 10 to 99 weight %.

28. The polymer anisotropic electroconductive composite adhesive material according to claim 27, **characterized in that** said material comprises, as the "common" low-molecular agents, monoglycidyl alcohol and phenol ethers, diglycidyl ether, diglycidyl diol and diphenol ethers, glycidyl amine derivatives, methylol phenol derivatives, colophony, diisocyanates, diols, methacrylates, acrylates, α-cyanacrylates, plastifiers, hardening agents.

29. The polymer anisotropic electroconductive composite adhesive material according to claim 27, **characterized in that** said material comprises, as the "common" oligomer agents: phenol-formaldehyde oligomers, oligomer diols, oligomer diisocyanares and/or oligomer polyphenols.

30. The polymer anisotropic electroconductive composite adhesive material according to claim 27, **characterized in that** said material comprises, as "common" polymer agents: aliphatic polyesters, aromatic polyesters, aromatic polyethers, polyacrylates and polymethacrylates, polyvinyl acetates and polyvinyl ketals, polyurethanes and polyureas, cross-linked polyepoxides formed during adhering, cross-linked phenol-formaldehyde systems formed during adhering.

31. A method for adhering while using the polymer anisotropic electroconductive composite adhesive material according to claim 1, **characterized in that** the method comprising steps of: applying, onto surfaces being adhered, a solution of said material in an organic solvent, joining the surfaces being adhered after evaporating the solvent, and pressing the surfaces being adhered while thermal processing till melting said material or till melting with chemical interaction of components of said material, which results in creating linear or cross-linked polymer systems.

32. A method for adhering while using the polymer anisotropic electroconductive composite adhesive material according to claim 1, **characterized in that** the method comprising steps of: applying, onto surfaces being adhered, said liquid material, joining the surfaces being adhered, and pressing the surfaces being adhered while thermal processing, which provides better spreading or better spreading and progressing the chemical interaction, which results in creating linear or cross-linked polymer systems.

33. A method for adhering while using the polymer anisotropic electroconductive composite adhesive material according to claim 1, **characterized in that** the method comprising steps of: placing said material in the form of film between surfaces being adhered, joining the surfaces being adhered, and pressing the surfaces being adhered while thermal processing, which provides better spreading or better spreading and progressing the chemical interaction, which results in creating linear or cross-linked polymer systems.
